# EUROPEAN PATENT APPLICATION

(11) **EP 4 836 671 A1**
(43) Date of publication of application: **04.11.2026**
(21) Application number: 26174219.1
(22) Date of filing: 23.04.2026
(51) Int. Cl.: H10W 44/00, H10W 42/80, H10W 74/10, H10W 76/12, H10W 90/10, H10W 90/00

(54) **POWER MODULE, POWER CONVERTER, AND PHOTOVOLTAIC POWER GENERATION SYSTEM**

(30) Priority: 28.04.2025 CN 202520831992 U
(71) Applicant: HUAWEI TECHNOLOGIES CO., LTD., Shenzhen 518129 (CN)
(72) Inventor: Zhou, Jiakan, Shenzhen, 518129 (CN); Wang, Jianli, Shenzhen, 518129 (CN); Liu, Zhiling, Shenzhen, 518129 (CN)
(74) Representative: Epping - Hermann - Fischer

(57) **Abstract**

This application provides a power module, a power converter, and a photovoltaic power generation system. The power module includes a substrate, a power device, a package body, and at least two pins. The power device is electrically connected to the substrate. The package body may package the substrate and the power device. The pin is electrically connected to the substrate and penetrates the package body, to extend out of the power module and connect to the circuit board. A protrusion or a groove is provided on a side that is of the package body and that is away from the substrate, and the protrusion or the groove is at least partially located between two adjacent pins. When a current flows through the pins, even if a spacing between the two adjacent pins is shortened, the protrusion or the groove between the two pins can increase a creepage distance between the two pins, so that working and safety performance of the power module are improved.

## Description

### TECHNICAL FIELD

This application relates to the field of energy technologies, and in particular, to a power module, a power converter, and a photovoltaic power generation system.

### BACKGROUND

A power module is an integral functional module obtained by combining power devices based on specific functions and then plastically packaging or potting the combined power devices as a whole, and is widely used in devices such as a servo motor, a frequency converter, or an inverter. A common packaging form of the power module includes plastic housing packaging, molding packaging, and the like, and is mainly to assemble and weld a substrate, a chip, a pin, and the like, and then protect the foregoing components by filling a package material.

To ensure safety of the power module, a creepage distance between a plurality of pins of the power module needs to satisfy a safety requirement. As an access voltage level of the power module continuously increases, the creepage distance between the plurality of pins needs to gradually increase. However, the increase in the creepage distance reduces mutual inductance when a current flows through the pins, and increases a parasitic parameter of a loop, thereby causing a voltage peak during power conversion.

### SUMMARY

This application provides a power module, a power converter, and a photovoltaic power generation system, to increase a creepage distance between two adjacent pins while shortening a spacing between the two pins, so as to improve performance of the power module.

According to a first aspect, this application provides a power module. The power module includes a substrate, a power device, a package body, and at least two pins. Specifically, the power device is disposed on a surface on a side of the substrate, and the power device is electrically connected to the substrate. The package body may package the substrate and the power device. The at least two pins each are separately electrically connected to the substrate, and the at least two pins pass through the package body and extend out of the power module from a surface on a side that is of the package body and that is away from the substrate. A protrusion or a groove is provided on the side that is of the package body and that is away from the substrate, and the protrusion or the groove is at least partially located between two adjacent pins in the at least two pins.

The power module in this application may be used in a power converter with a high voltage. In the power module, the pins extend out of the power module from a side relative to the substrate and are connected to a circuit board of the power converter. When the power module works, a current flows through the pins. A protrusion or groove is provided between two adjacent pins. Therefore, even if a spacing between the two adjacent pins is shortened, the protrusion or the groove between the two pins can increase a creepage distance between the two pins, so that working and safety performance of the power module are improved.

In an implementation, the protrusion or the groove is provided in the surface on the side that is of the package body and that is away from the substrate, and the protrusion or the groove is located between the two pins. In this implementation, the protrusion or the groove may be directly provided in an outer surface of the package body, and may be formed together with the package body in a preparation process of the power module, so that preparation costs of the power module are reduced.

In an implementation, a height of the protrusion may be less than lengths by which the two pins extend out of the power module. Therefore, when the power module is assembled with the circuit board of the power converter, the two pins are directly connected to the circuit board. Because the height of the protrusion is less than a length of the pin located between the package body and the circuit board, the protrusion does not affect a connection between the pin and the circuit board, and an end that is of the pin and that is away from the package body may be directly connected to the circuit board.

In an implementation, a height of the protrusion is greater than lengths by which the two pins extend out of the power module. The protrusion is connected to an end of the package body and is disposed in parallel with the two pins, and an end that is of the protrusion and that is away from the package body is located on a side that is of the two pins and that is away from the package body, and extends in a direction parallel to a plane on which the package body is located. In this implementation, the height of the protrusion is greater than the length of the pin located between the package body and the circuit board, so that the creepage distance between the two pins can be further increased. In this case, a recess may be provided in the circuit board of the power converter to accommodate the protrusion.

In an implementation, the package body includes a cover and a plastic package body, the plastic package body wraps the power device, and the cover is disposed on the surface on the side that is of the plastic package body and that is away from the substrate. The cover at least partially covers the surface of the plastic package body. In this implementation, plastic housing packaging may be adopted for the power module. Specifically, the cover may completely cover the surface of the plastic package body and be connected to the substrate, and the plastic package body is located in space between the cover and the substrate. Alternatively, molding packaging may be adopted for the power module. Specifically, a part of the surface of the plastic package body is covered by the cover, and another part is exposed outside the cover.

In an implementation, an insulation pad is disposed between the cover and the plastic package body. The protrusion is disposed on a surface on a side that is of the insulation pad and that faces the cover, and the protrusion passes through the cover and extends out of the power module. The two pins penetrate the protrusion and extend out of the power module. In this implementation, the protrusion is disposed on the insulation pad. Specifically, the protrusion of the insulation pad penetrates from a side that is of the cover and that is located in the power module to another side that is located outside the power module. The pin penetrates the protrusion, in other words, the protrusion wraps a part that is of the pin and that extends out of the power module. In this way, the creepage distance between two adjacent pins includes a surface of the cover and a surface of the protrusion between the two pins, so that the creepage distance is increased.

In an implementation, an insulation layer is disposed on a surface of the protrusion or the groove, to increase a comparative tracking index (CTI) of the surface of the protrusion or the groove, and further improve insulation performance of the protrusion or the groove.

In an implementation, current directions of the two pins are opposite. When the power module is connected to the circuit board and powered on, potentials of two adjacent pins may be different. In this way, a spacing between the two pins can be shortened without affecting safety, so that mutual inductance when a current flows through the pins is increased, to reduce a parasitic inductance and a voltage peak risk.

According to a second aspect, this application further provides a power converter. The power converter includes a circuit board and the power module according to the first aspect. The circuit board is located on the side that is of the package body and that is away from the substrate, and the at least two pins are connected to the circuit board. In the power converter in this application, a spacing between two adjacent pins of the power module is short, and a creepage distance is large, so that working and safety performance of the power module are good.

In an implementation, the protrusion is disposed on the side that is of the package body and that is away from the substrate, the protrusion is located between the two pins, and the height of the protrusion is greater than the lengths by which the two pins extend out of the power module. A recess is provided in a surface on a side that is of the circuit board and that faces the power module, an end that is of the protrusion and that is close to the package body is disposed in parallel with the two pins, and the end that is of the protrusion and that is away from the package body is located in the recess. In this implementation, the height of the protrusion is greater than the length of the pin between the power module and the circuit board, so that the creepage distance between the two pins can be further increased. In this case, the recess may be provided in the circuit board of the power converter to accommodate the protrusion.

According to a third aspect, this application further provides a photovoltaic power generation system. The photovoltaic power generation system includes a photovoltaic module and the power converter according to the second aspect. The photovoltaic module is connected to the power converter, and the power converter is configured to perform power conversion on a direct current output by the photovoltaic module. In the photovoltaic power generation system in this application, a spacing between two adjacent pins of the power module in the power converter is short, and a creepage distance is large, so that working and safety performance of the power module are good.

### BRIEF DESCRIPTION OF DRAWINGS

FIG. 1 is a diagram of a photovoltaic power generation system according to an embodiment of this application;
FIG. 2 is a diagram of a power converter according to an embodiment of this application;
FIG. 3 is a diagram of a power converter according to an embodiment of this application;
FIG. 4 is a diagram of a power converter according to an embodiment of this application;
FIG. 5 is a diagram of a power converter according to another embodiment of this application;
FIG. 6 is a diagram of a power converter according to another embodiment of this application;
FIG. 7 is a diagram of a power converter according to another embodiment of this application;
FIG. 8 is a diagram of a power module in FIG. 4;
FIG. 9 is a diagram of a power module in FIG. 5;
FIG. 10 is a diagram of a power module according to an embodiment of this application;
FIG. 11 is a diagram of a power converter according to another embodiment of this application; and
FIG. 12 is a diagram of a power module in FIG. 11.

Reference numerals:
10: photovoltaic power generation system;
11: photovoltaic module;
12: power converter;
13: power grid;
14: load;
20: power module;
21: pin;
22: substrate;
23: power device;
24: package body;
25: protrusion;
26: groove;
121: circuit board;
241: plastic package body;
242: cover; and
243: insulation pad.

### DESCRIPTION OF EMBODIMENTS

To make the objectives, technical solutions, and advantages of this application clearer, the following further describes this application in detail with reference to the accompanying drawings.

To facilitate understanding of a power module, a power converter, and a photovoltaic power generation system provided in embodiments of this application, the following describes application scenarios of the power module, the power converter, and the photovoltaic power generation system. The power converter is widely used in scenarios such as a photovoltaic power generation system, an energy storage system, or a powertrain system of a new energy vehicle, and is configured to perform power conversion on a current or voltage in an application system. The power converter may include an inverter or a micro inverter in the photovoltaic power generation system, a converter in the energy storage system, a motor control unit in a powertrain of the new energy vehicle, or the like.

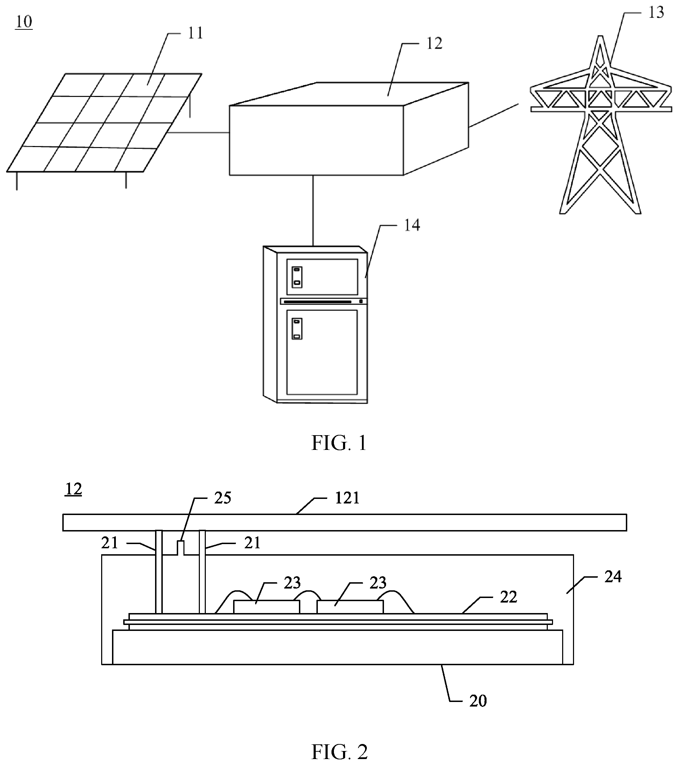

The photovoltaic power generation system is used as an example. The photovoltaic power generation system may be used in application scenarios such as a home power station and an industrial photovoltaic power station. The photovoltaic power generation system is configured to: convert solar energy into electric energy and supply the electric energy to a power grid or a load. FIG. 1 is a diagram of a photovoltaic power generation system according to an embodiment of this application. As shown in FIG. 1, a photovoltaic power generation system 10 may include a photovoltaic module 11 and a power converter 12. An output end of the photovoltaic module 11 is connected to an input end of the power converter 12. The power converter 12 is configured to: perform power conversion on a direct current output by the photovoltaic module 11, and output the direct current to a power grid 13 or a load 14.

FIG. 2 is a diagram of a power converter according to an embodiment of this application. As shown in FIG. 2, the power converter 12 includes a circuit board 121 and a power module 20. The power module 20 is disposed on a side of the circuit board 121 and is electrically connected to the circuit board 121. Specifically, the power module 20 includes at least two pins 21, and parts that are of the at least two pins 21 and that extend out of the power module 20 are connected to the circuit board 121.

To ensure safety of the power module, a creepage distance between two adjacent pins needs to satisfy a safety requirement. It should be noted that, the creepage distance is a charged region between two conductive parts measured along an insulation surface, where the charged region is a region in which in different use cases, insulation materials are charged because the insulation materials around a conductor are electrically polarized. The charged region is usually formulated based on safety requirements. In this embodiment of this application, the creepage distance is a distance between two adjacent pins along an outer surface of the power module. Therefore, along the outer surface of the power module, a spacing between two adjacent pins should satisfy the creepage distance.

As an access voltage level of the power module increases, the creepage distance gradually increases. However, the increase in the creepage distance causes an increase in the spacing between two adjacent pins, reduces a mutual inductance effect when a current flows through the two pins, and increases a parasitic parameter of a power circuit, thereby causing a voltage peak during power conversion.

In view of this, this application provides a power module, a power converter, and a photovoltaic power generation system, to increase a creepage distance between two adjacent pins while shortening a spacing between the two pins, so as to improve working and safety performance of the power module.

It should be noted that terms used in the following embodiments are merely intended to describe specific embodiments, but are not intended to limit this application. Terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

The terms "first", "second", and the like in this application are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, orientation terms such as "top", "bottom", "up", and "down" are defined relative to orientations of structures schematically placed in the accompanying drawings. It should be understood that these orientation terms are relative concepts used for relative description and clarification, and may correspondingly change based on changes in the orientations in which the structure are placed.

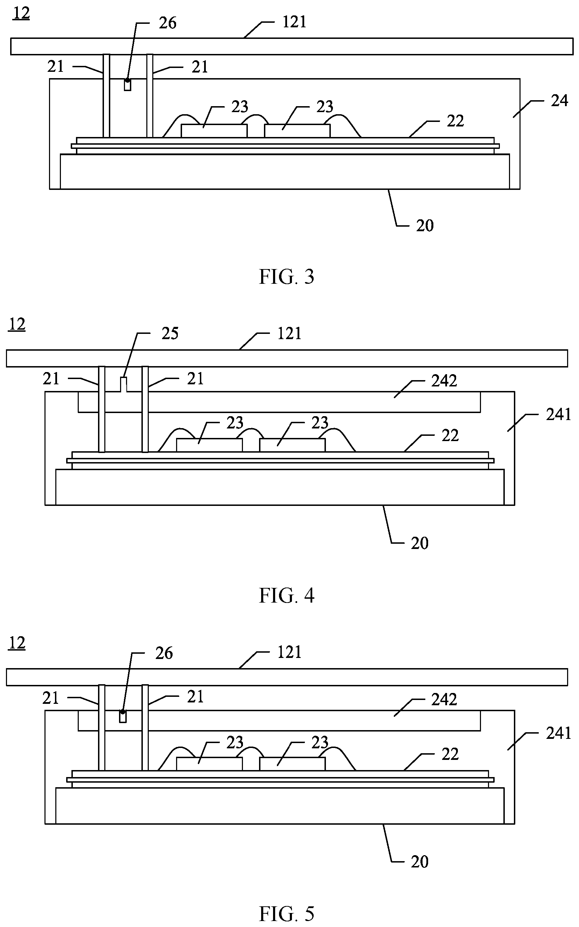

As shown in FIG. 2, the power module 20 further includes a substrate 22, a power device 23, and a package body 24. Specifically, the power device 23 is disposed on a surface on a side of the substrate 22, and the power device 23 is electrically connected to the substrate 22. The package body 24 is configured to package the substrate 22 and the power device 23. The at least two pins 21 are separately electrically connected to the substrate 22. The at least two pins 21 penetrate the package body 24, and extend out of the power module 20 from a surface on a side that is of the package body 24 and that is away from the substrate 22, and are configured to connect to the circuit board 121. A protrusion 25 may be disposed on the side that is of the package body 24 and that is away from the substrate 22, and the protrusion 25 or a groove 26 may be at least partially located between two adjacent pins 21 in the at least two pins 21. FIG. 3 is a diagram of the power converter according to another embodiment of this application. As shown in FIG. 3, the groove 26 may alternatively be provided on the side that is of the package body 24 and that is away from the substrate 22, and the groove 26 may be at least partially located between two adjacent pins 21 in the at least two pins 21.

It should be noted that, the package body 24 may be provided with only the protrusion 25, or the package body 24 may be provided with only the groove 26, or the package body 24 may be provided with the protrusion 25 and the groove 26. This is not limited in embodiments of this application.

The power module 20 may be used in a power converter 12 with a high voltage. In the power module 20, the pins 21 extend out of the power module 20 from a side relative to the substrate 22 and are connected to the circuit board 121 of the power converter 12. When the power module 20 works, a current flows through the pins 21, and the protrusion 25 or the groove 26 is provided between two adjacent pins 21. Therefore, even if a spacing between the two pins 21 is shortened, the protrusion 25 or the groove 26 between the two pins 21 can increase a creepage distance between the two pins 21, so that working and safety performance of the power module 20 are improved.

FIG. 4 is a diagram of the power converter according to another embodiment of this application. FIG. 5 is a diagram of the power converter according to another embodiment of this application. As shown in FIG. 4 and FIG. 5, the package body 24 includes a plastic package body 241 and a cover 242. The plastic package body 241 wraps the power device 23, the cover 242 is disposed on a surface on a side that is of the plastic package body 241 and that is away from the substrate 22, and the cover 242 at least partially covers the surface on the side that is of the plastic package body 241 and that is away from the substrate 22. The protrusion 25 and/or the groove 26 may be provided in the cover 242.

As shown in FIG. 4, in an embodiment, molding packaging may be adopted for the power module 20. Specifically, the plastic package body 241 includes two opposite sides, where the substrate 22 and the power device 23 are packaged at one side, and the cover 242 is packaged at the other side. In other words, the cover 242 covers one part of the surface on the side that is of the plastic package body 241 and that is away from the substrate 22, and another part of the surface is exposed outside the cover 242.

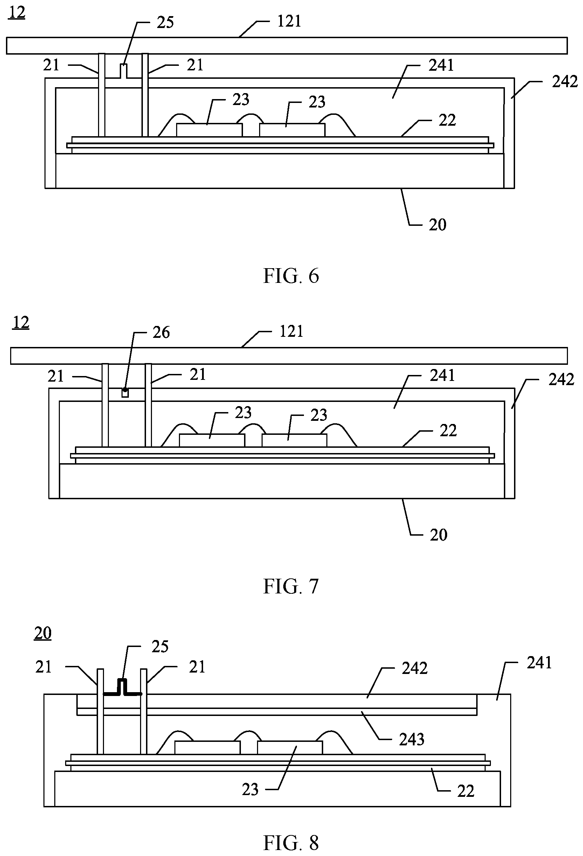

FIG. 6 is a diagram of the power converter according to another embodiment of this application. FIG. 7 is a diagram of the power converter according to another embodiment of this application. As shown in FIG. 6 and FIG. 7, housing packaging may be adopted for the power module 20. Specifically, the plastic package body 241 packages the substrate 22 and the power device 23, and the cover 242 is disposed on a side that is of the plastic package body 241 and that is away from the substrate 22 and completely covers the plastic package body 241.

The following uses the power module 20 in molding packaging as an example for description.

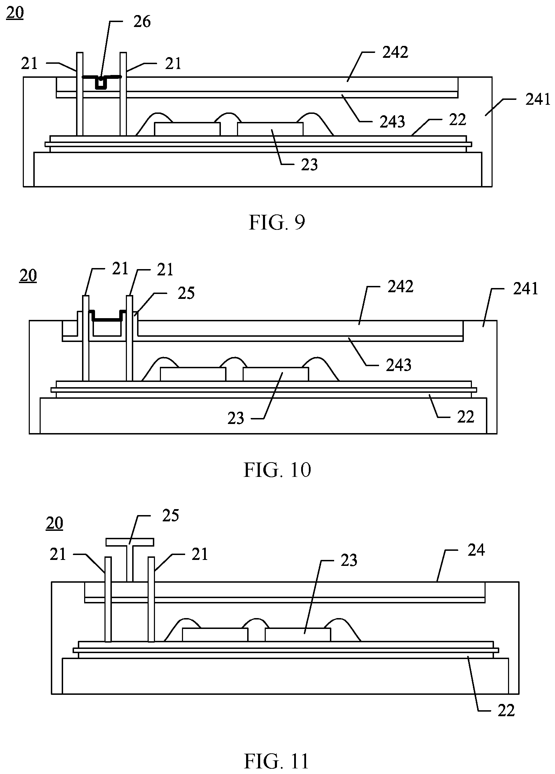

FIG. 8 is a diagram of the power module in FIG. 4. FIG. 9 is a diagram of the power module in FIG. 5. As shown in FIG. 8 and FIG. 9, an insulation pad 243 is disposed between the cover 242 and the plastic package body 241. The insulation pad 243 may be configured to increase a heat dissipation area between the power device 23 and the cover 242, to achieve temperature uniformity of the cover 242. In addition, the insulation pad 243 can prevent high-voltage breakdown between the power device 23 and the cover 242, to reduce a risk of a short circuit.

As shown in FIG. 8 and FIG. 9, in some embodiments, the protrusion 25 or the groove 26 may be directly provided in an outer surface of the cover 242, and the protrusion 25 or the groove 26 is located between two pins 21. In this case, a creepage distance between two adjacent pins 21 is shown by using bold solid lines in FIG. 8 and FIG. 9. When the power module 20 is prepared, the protrusion 25 or the groove 26 may be formed when the cover 242 is prepared through injection molding, so that preparation costs of the cover 242 are reduced.

FIG. 10 is a diagram of the power module according to an embodiment of this application. As shown in FIG. 10, the protrusion 25 may alternatively be disposed on the insulation pad 243. Specifically, the protrusion 25 is disposed on a surface on a side that is of the insulation pad 243 and that faces the cover 242, and the protrusion 25 passes through the cover 242 and extends out of the power module 20. The pin 21 penetrates the protrusion 25 and extends out of the power module 20.

In this embodiment, the protrusion 25 of the insulation pad 243 penetrates from one side that is of the cover 242 and that is located in the power module 20 to another side of the power module 20. The pin 21 penetrates the protrusion 25, in other words, the protrusion 25 wraps a part that is of the pin 21 and that extends out of the power module 20. In this case, a creepage distance between two adjacent pins 21 is shown by using a bold solid line in FIG. 10. In this way, the creepage distance between the two adjacent pins 21 includes a surface of the cover 242 and a surface of the protrusion 25 between the two pins 21, so that the creepage distance is increased.

Certainly, in another embodiment, the protrusion 25 may be disposed on the insulation pad 243, and the protrusion 25 and/or the groove 26 may be provided in the cover 242.

In the foregoing embodiment, an insulation layer may be disposed on the surface of the protrusion 25 and the surface of the groove 26, to increase a comparative tracking index (CTI) of the surface of the protrusion 25, and further improve insulation performance of the protrusion 25.

As shown in FIG. 8 and FIG. 10, a height of the protrusion 25 may be less than lengths by which the two adjacent pins 21 extend out of the power module 20. Therefore, when the power module 20 is assembled with the circuit board 121 of the power converter 12, the two pins 21 are directly connected to the circuit board 121. Because the height of the protrusion 25 is less than a length of the pin 21 located between the package body 24 and the circuit board 121, the protrusion 25 does not affect a connection between the pin 21 and the circuit board 121, and an end that is of the pin 21 and that is away from the package body 24 may be directly connected to the circuit board 121.

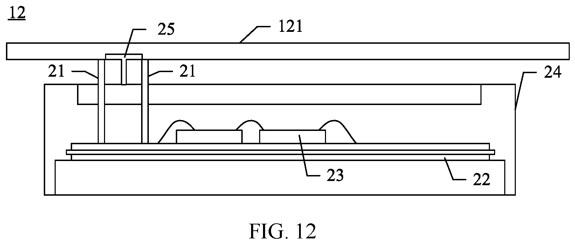

FIG. 11 is a diagram of the power converter according to another embodiment of this application. FIG. 12 is a diagram of the power module in FIG. 11. As shown in FIG. 11 and FIG. 12, a height of the protrusion 25 is greater than lengths by which the two pins 21 extend out of the power module 20. The protrusion 25 is connected to an end of the package body 24 and is disposed in parallel with the two pins 21, and an end that is of the protrusion 25 and that is away from the package body 24 is located on a side that is of the two pins 21 and that is away from the package body 24, and extends in a direction parallel to a plane on which the cover 242 is located. In this implementation, the height of the protrusion 25 is greater than the length of the pin 21 located between the package body 24 and the circuit board 121, so that the creepage distance between the two pins 21 can be further increased. In this case, a recess may be provided in the circuit board 121 of the power converter 12, to accommodate the protrusion 25.

In some embodiments, current directions of the two pins 21 may be opposite. Therefore, when the power module 20 is connected to the circuit board 121 and powered on, potentials of two adjacent pins 21 are different. In this way, a spacing between the two pins 21 can be shortened without affecting safety, so that mutual inductance when a current flows through the pins 21 is increased, to reduce parasitic inductance and a voltage peak risk.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising a substrate, a power device, and a package body, wherein
the power device is disposed on a surface on a side of the substrate, and the power device is electrically connected to the substrate;
the package body packages the substrate and the power device; and the power module further comprises at least two pins, the at least two pins are separately electrically connected to the substrate, and the at least two pins pass through the package body and extend out of the power module from a surface on a side that is of the package body and that is away from the substrate; and
a protrusion or a groove is provided on the side that is of the package body and that is away from the substrate, and the protrusion or the groove is at least partially located between two adjacent pins in the at least two pins.

2. The power module according to claim 1, wherein the protrusion or the groove is provided in the surface on the side that is of the package body and that is away from the substrate, and the protrusion or the groove is located between the two pins.

3. The power module according to claim 2, wherein a height of the protrusion is less than lengths by which the two pins extend out of the power module.

4. The power module according to claim 2, wherein a height of the protrusion is greater than lengths by which the two pins extend out of the power module; and the protrusion is connected to an end of the package body and is disposed in parallel with the two pins, and an end that is of the protrusion and that is away from the package body is located on a side that is of the two pins and that is away from the package body, and extends in a direction parallel to a plane on which the package body is located.

5. The power module according to any one of claims 1 to 4, wherein the package body comprises a cover and a plastic package body, the plastic package body wraps the power device, the cover is disposed on a surface on a side that is of the plastic package body and that is away from the substrate, and the cover at least partially covers the surface of the plastic package body.

6. The power module according to claim 5, wherein an insulation pad is disposed between the cover and the plastic package body, the protrusion is disposed on a surface on a side that is of the insulation pad and that faces the cover, and the protrusion passes through the cover and extends out of the power module; and the two pins penetrate the protrusion and extend out of the power module.

7. The power module according to any one of claims 1 to 6, wherein an insulation layer is disposed on a surface of the protrusion or the groove.

8. The power module according to any one of claims 1 to 7, wherein current directions of the two pins are opposite.

9. A power converter, comprising a circuit board and the power module according to any one of claims 1 to 8, wherein the circuit board is located on the side that is of the package body and that is away from the substrate, and the at least two pins are connected to the circuit board.

10. The power converter according to claim 9, wherein the protrusion is disposed on the side that is of the package body and that is away from the substrate, the protrusion is located between the two pins, and the height of the protrusion is greater than the lengths by which the two pins extend out of the power module; and
a recess is provided in a surface on a side that is of the circuit board and that faces the power module, an end that is of the protrusion and that is close to the package body is disposed in parallel with the two pins, and the end that is of the protrusion and that is away from the package body is located in the recess.

11. A photovoltaic power generation system, comprising a photovoltaic module and the power converter according to claim 9 or 10, wherein the photovoltaic module is connected to the power converter, and the power converter is configured to perform power conversion on a direct current output by the photovoltaic module.
